(19) **Europäisches Patentamt / European Patent Office / Office européen des brevets**

(11) **EP 3 766 114 B1**

(12) # EUROPEAN PATENT SPECIFICATION

(45) Date of publication and mention
of the grant of the patent:
**25.03.2026 Bulletin 2026/13**

(21) Application number: **19766551.6**

(22) Date of filing: **12.03.2019**

(51) International Patent Classification (IPC):
**H10N 70/00** *(2023.01)* **H10N 70/20** *(2023.01)*

(52) Cooperative Patent Classification (CPC):
**H10N 70/235; H10N 70/8836;** Y02E 60/50;
Y02P 70/50

(86) International application number:
**PCT/US2019/021713**

(87) International publication number:
**WO 2019/178010 (19.09.2019 Gazette 2019/38)**

(54) **NON-CHEMICAL ELECTRIC BATTERY USING TWO PHASE WORKING MATERIAL**

NICHTCHEMISCHE ELEKTRISCHE BATTERIE MIT VERWENDUNG VON ZWEIPHASIGEM
ARBEITSMATERIAL

BATTERIE ÉLECTRIQUE NON CHIMIQUE UTILISANT UN MATÉRIAU DE TRAVAIL À DEUX
PHASES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.03.2018 US 201862644068 P
31.08.2018 US 201816120080**

(43) Date of publication of application:
**20.01.2021 Bulletin 2021/03**

(73) Proprietor: **Polymorph Quantum Energy Sarl
1273 Arzier-Le Muids (CH)**

(72) Inventor: **BARNES, Stewart Edward
1227 Carouge GE (CH)**

(56) References cited:
**US-A1- 2017 062 072 US-A1- 2017 352 802**

- CAO J ET AL: "Strain effects in low-dimensional transition metal oxides", 8 January 2011, MATERIALS SCIENCE AND ENGINEERING: R: REPORTS, ELSEVIER, AMSTERDAM, NL, PAGE(S) 35 - 52, ISSN: 0927-796X, XP027526878

- N. IZYUMSKAYA ET AL: "Oxides, Oxides, and More Oxides: High-&kgr; Oxides, Ferroelectrics, Ferromagnetics, and Multiferroics", CRITICAL REVIEWS IN SOLID STATE AND MATERIALS SCIENCES, vol. 34, no. 3-4, 30 November 2009 (2009-11-30), US, pages 89 - 179, XP055268298, ISSN: 1040-8436, DOI: 10.1080/ 10408430903368401

- N. IZYUMSKAYA ET AL: "Processing, Structure, Properties, and Applications of PZT Thin Films", CRITICAL REVIEWS IN SOLID STATE AND MATERIALS SCIENCES, vol. 32, no. 3, 1 July 2007 (2007-07-01), pages 111 - 202, XP055135036, ISSN: 1040-8436, DOI: 10.1080/ 10408430701707347

- CHIZHIK ALEXANDER ET AL: "Control of the domain wall motion in cylindrical magnetic wires", APPLIED PHYSICS LETTERS, AMERICAN INSTITUTE OF PHYSICS, 2 HUNTINGTON QUADRANGLE, MELVILLE, NY 11747, vol. 109, no. 5, 1 August 2016 (2016-08-01), XP012210035, ISSN: 0003-6951, [retrieved on 20160801], DOI: 10.1063/1.4960605

- XIAOJIAN ZHU ET AL: "In Situ Nanoscale Electric Field Control of Magnetism by Nanoionics", ADVANCED MATERIALS, VCH PUBLISHERS, DE, vol. 28, no. 35, 27 June 2016 (2016-06-27), pages 7658 - 7665, XP071870277, ISSN: 0935-9648, DOI: 10.1002/ADMA.201601425

**EP 3 766 114 B1**

**(Cont. next page)**

- **LI PENG ET AL: "High recoverable energy storage density and large piezoelectric response in (Bi0.5Na0.5)TiO3-PbTiO3thin films prepared by a sol-gel method", JOURNAL OF THE EUROPEAN CERAMIC SOCIETY, ELSEVIER, AMSTERDAM, NL, vol. 37, no. 10, 14 April 2017 (2017-04-14), pages 3319 - 3327, XP029989810, ISSN: 0955-2219, DOI: 10.1016/ J.JEURCERAMSOC.2017.03.024**
- **XIE ZHENKUN ET AL: "Large enhancement of the recoverable energy storage density and piezoelectric response in relaxor-ferroelectric capacitors by utilizing the seeding layers engineering", APPLIED PHYSICS LETTERS, AMERICAN INSTITUTE OF PHYSICS, 2 HUNTINGTON QUADRANGLE, MELVILLE, NY 11747, vol. 106, no. 20, 18 May 2015 (2015-05-18), XP012197547, ISSN: 0003-6951, [retrieved on 19010101], DOI: 10.1063/1.4921404**

- **MCMICHAEL, R ET AL.: "A new connection between electricity and magnetism", PHYSICS, vol. 1, no. 3, 9 February 2009 (2009-02-09), XP055637015, Retrieved from the Internet <URL:https://pdfs.semanticscholar.org/32b7/ e4e02683b5dc093b78816a836a68da78dccc.pdf> [retrieved on 20190530]**

**Description**

**CROSS REFERENCE TO RELATED APPLICATIONS**

The present application claims the priority benefit of U.S. provisional patent application no. 62/644,068, filed on March 16, 2018, titled "Non-Electrical Chemical Battery Using Two-Phase Working Material," published as patent application publication US 2019/0288278 Al.

**BACKGROUND**

Energy storage is a crucial component to increasingly large number situations, e.g., in powering electrical vehicles, portable devices, and storage and mobile use of solar power. The current state of the art has electrical energy stored, e.g., in a battery in chemical form, while in a capacitor it is in an electric field and polarization of a dielectric material, it is in magnetic form in a superconducting loop, in mechanical form in a flywheel generator combination, or gravitational form, in a hydroelectric installation.

The current benchmarks for energy sources have nuclear at $1.5 \times 10^{18} J/m^3$ (Uranium breeder reactor) while for fossil fuels $\approx 4 \times 10^{10} J/m^3$ (Kerosene) and current Li-ion chemical batteries $\approx 1 \times 10^9 J/m^3$ and $\approx 5 \times 10^7 J/m^3$ for super-capacitors. Excluding nuclear power and given fossil fuel engines are less than 50% efficient, an idea electrical battery would correspond to an energy density $\approx 2 \times 10^{10} J/m^3$ and a high-power density, i.e., large currents upon charge and discharge.

Apart from nuclear, all these sources of energy correspond to atomic physics, and this implies certain general limits on the energy density. For example, the discharge of a chemical battery involves the transfer of electrons between the outer orbitals of atoms. The energies involved are scaled by the Rydberg 13.6eV, and so the transfer of an electron involves an energy that are invariably less than or of the order of this and corresponding to a of electrical potential difference of about 13.6V.

As is explained in elementary chemistry texts, the voltage and the maximum energy density of an electro-chemical battery are easily calculated from the table of standard electrode potentials. For example, with the usual $LiCoO_2$ cathode the Li/Co redox couple gives a difference in standard potentials, and hence an electromotive force (EMF), of 3.60Volts. With about $10^{28}$atoms/$m^3$, the ideal limit is 3.6V $x1.6 \times 10^{-19}$J/V $x10^{28} \rightarrow 6.8 \times 10^9 J/m^3$ and a factor of about ten times greater than the best chemical Li-ion batteries. today. Despite decades of intensive research, the theoretical performance has never been achieved.

Since the electric field that an insulating material can withstand without breakdown is similarly limited, this estimate also applies to capacitors and the "phase battery" described here.

Chemical batteries have a limited power density that reflects the slow ionic transport and results in poor charge and discharge performance. Furthermore, the reliance of existing batteries on ionic transport invariably causes high degradation rates of the batteries materials. On the other hand, capacitors involve rapid electronic transport with a correspondingly higher power density but have a very small fraction of useful working material and correspondingly small energy densities.

There are first order phase transitions that occur between phases with different electrical character and structures. The "phase battery" described here has two phases A and B separated by a mobile phase domain wall. The voltage V developed across the phase domain wall keeps in equilibrium phases that would only be in equilibrium under extreme condition. The EMF seated in the phase wall is equal to the equilibrium voltage $V = (\mu_A - \mu_B)/e$ where, e.g., $\mu_A/e$ is the chemical potential of phase A measured in electron volts. As with a chemical battery, V can be calculated from the energies of formation data published, e.g., by the "Materials Project". To compete with the best chemical batteries, a phase energy difference $\mu_A - \mu_B \sim 10eV/atom$ is required. Such materials are not common but do exist.

Since the working phase charge material occupies the entire volume of the battery, these concepts permit the design of a battery that approaches the atomic physics limits described above.

What is needed is an improved energy storage technology described here within.

**SUMMARY**

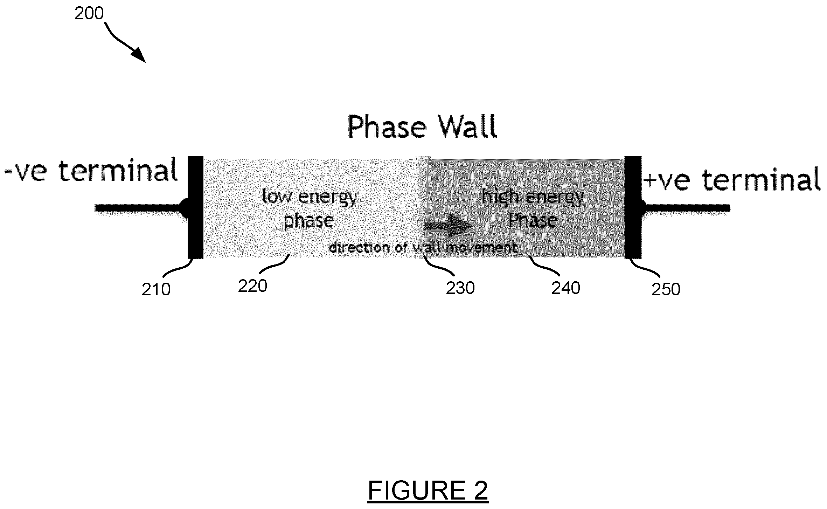

The present technology, with the embodiment of FIGURE 2, uses an energy storage material that occupies most of the phase battery volume and operates via electronic transport. This material, of approximately fixed volume, includes a first portion A of a working material having a first phase and higher absolute energy density, a second portion B having a second phase and a lower absolute energy density. These are separated by a phase wall. There is an external circuit that connects the first and second portions of the material. As the first order phase transition proceeds, the wall is displaced causing the volume of the first portion to increase at the expense of the volume of the second portion thereby decreasing the total stored energy. This spontaneous phase wall motion, corresponding to discharge, causes a current to flow in the external circuit. During the charging cycle a current is driven in the opposite sense causing the phase wall motion to be reversed. Now the proportion of the first, high energy density portion, increases at the expense of the second low energy part and the total stored energy is restored.

In the special situation when two phases A and B are separated by a single *mobile* phase domain wall, the phases are brought into equilibrium by a voltage $V = (\mu_A - \mu_B)/e$ where, e.g., $\mu_A/e$ is the chemical potential of phase A measured in electron volts. The quantity $\mu_A - \mu_B$ is the difference in the energy of formation found, e.g., at "The Materials Project". The projected EMF equal to $V$ is thereby easily calculated.

Then given $\mu_A > \mu_B$, when $V > (\mu_A - \mu_B)/e$ phase A grows at the expense of phase $B$ and the battery is charged and discharged when $V < (\mu_A - \mu_B)/e$. This reflects the known physics of *athermal* electrically driven phase transitions but is usually hidden by *thermal* relaxation effects.

The predicted EMF $(\mu_A - \mu_B)/e$, seated within the phase wall, appears in any circuit that includes the phase wall, i.e., as in FIGURE 2, one terminal of the battery is connected to phase $A$ and the other to phase $B$. This physics is a mathematical outgrowth of the confirmed prediction of a spin-motive force (SMF) produced by a moving magnetic domain wall and more generally relates to "emergent electromagnetism".

A $V$ of a few volts is equivalent to a pressure well over 100GPa. A modest voltage can thereby bring into equilibrium phases that otherwise would only be in equilibrium under extreme conditions. This is key to the concept of a phase battery. The principal difficulty is the realization of the necessary high quality single crystals that support a single mobile phase domain wall.

## BRIEF DESCRIPTION OF FIGURES

FIGURE 1 is a block diagram of a ferromagnetic wire having magnetic domain wall which drives a spin motive force.
FIGURE 2 is a block diagram of the basic structure of an energy storage device.
FIGURE 3 Supplementary data illustrating the athermal displacement of a phase wall by an applied voltage/current.
FIGURE 4 Supplementary data shown the effective circuit of a phase battery
FIGURE 5 illustrates plots of the energy E, minus the value for the bcc structure, in eV/atom.
FIGURE 6 illustrates a schematic of a phase transition battery based upon different chemical phases.

## DETAILED DESCRIPTION

The present technology, roughly described, has an energy storage material that occupies most of a battery volume and operates via electronic transport. The energy storage material, of approximately fixed volume, includes a first potion of a working material having a first phase and higher absolute energy density, a second portion of a working material having a second phase and a lower absolute energy density. These are separated by a phase-wall. There is an external circuit that connects the first and second portions of the material. As a first order phase transition proceeds, the phase wall is displaced causing the volume of the first portion to increase at the expense of the volume of the second portion and decreasing the total stored energy. This spontaneous phase wall motion, corresponding to discharge, causes a current to flow in the external circuit. During the charging cycle a current is driven, by an external power source, in the opposite sense causing the phase wall motion to be reversed. Now the proportion of the first, high energy density part, increases at the expense of the second low energy part and the total stored energy is restored.

In this description, the word "phase" is used in the technical sense defined by the International Union of Pure and Applied Chemists (IUPAC) "Definitions of terms relating to phase transitions of the solid state" IUPAC, 2004, 76, 1985: as "an entity of a material system which is uniform in chemical composition and physical state", e.g., a solid with a given crystal and electronic structure and represented by a specific chemical formula. It is common knowledge that many materials have more than one phase, i.e., has different polymorphs (or allotropes for an element). Example: At ambient conditions $FeTiO_3$, has the ilmenite structure but at higher pressure assumes the perovskite structure.

The words "phase transition" means, following the IUPAC: "A change in the nature of a phase as a result of some variation in externally imposed conditions, such as temperature, pressure, activity of a component or a magnetic, electric or stress field".

Following the IUPAC, the words "first-order phase transition" reflects "a transition in which the molar Gibbs energies of the two phases are equal at the transition temperature $T$, but their first derivatives with respect to temperature and pressure $P$ (and other extensive variables) are discontinuous at the transition point. The two coexisting phases can be transformed into one another by a change in an extensive variable such as pressure, temperature, magnetic or electric field". Such transitions exhibit a non-zero *latent heat* $Q = T\Delta S$ where $\Delta S$ is the change in entropy. The latent heat can be large with $Q \cong 0.4$eV/molecule for the steam/water transition.

Example: When the transition between the ilmenite and perovskite structures of $FeTiO_3$. induced by *pressure,* many physical properties exhibit singular behavior with, for this example, a sudden change in the lattice parameters, the entropy, and cell volume. The same material undergoes a *valence state transition.* The lowest energy polymorph of $FeTiO_3$ has nominal electronic charges $Fe^{2+}Ti^{4+}O^{-2}_2$ but makes a first order phase transition to a second polymorph in which the nominal ionic charges are $Fe^{3+}Ti^{3+}O^{-2}_2$.

The words "Mott", "Jahn-Teller "and "Peierls" qualify first order phase transitions, following the IUPAC definitions. Either alone, or in concert, these frequently lead to first order "metal-insulator (phase) transitions" (MIT), i.e., transitions of a material from an insulator, semiconductor or semi-metal high resistance state (HRS) to metal low resistive states (LRS). Much studied examples are the MIT transitions of $VO_2$ and $Ca_2RuO_4$

The words "metal-insulator phase transition" do *not* refer to, the *ill-defined* change between a HRS and LRS of $\alpha$-LiFe$_5$O$_8$ as described in the publication titled "In Situ Nanoscale Electric Field Control of Magnetism by Nanoionics" by Zhu, Xiaojian et al., Advanced Materials, vol. 28, no. 35, 1 September 2016 (2016-09-01), pages 7658-7665, DE ISSN: 0935-9648, DOI: 10.1002/adma.201601425 . Following the IUPAC definitions this is not a first order phase transition. It is claimed by Zhu Xiaojian et al., that this resistive change "arises from ionic transport of Li$^+$ and a redox reaction with Fe$^{2+}$ thereby changing the magnetic properties". On the other hand, Tsuneo Matsui and J. Bruce Wagner Jr. 1977 J. Electrochem. Soc. 124 1141, disclose that LFO has uniquely a *well-defined* polymorphic phase transition to the disordered β-LiFe$_5$O$_8$ phase at about 1010K accompanied, with a small resistive change, and has a Curie (ferromagnetic ordering) temperature reported at 940K also with a small change in resistance. Following the IUPAC definitions, the ill-defined LRS/HRS state transition of the devices published by Zhu, Xiaojian et al., *cannot* be identified with these phase transitions since the temperatures of these transitions is too high, and the resistive changes too small. Further, due to the ionic transport of Li$^+$, the material in this device is composed of an ill-defined inhomogenous composition somewhere between the well-defined phases $\alpha$-LiFe$_5$O$_8$ and the probably unstable FesOs.

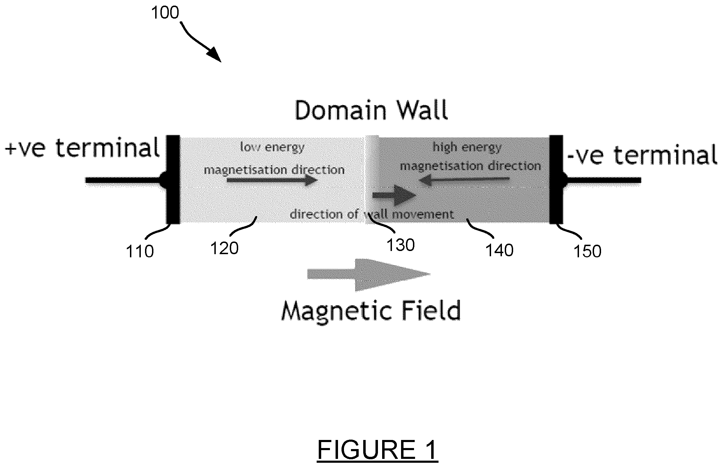

The words "phase domain wall" or "phase wall" or for short "domain wall", all refer to a "wall" that forms between two different *phases,* i.e., polymorphs or allotropes of a single material, e.g., between the ilmenite and perovskite phase of FeTiO$_3$. The difference in energy of these polymorphs of FeTiO$_3$ is *intrinsic.* Such walls are distinct from "magnetic domain walls" that connect two magnetic domains, i.e., regions in which the magnetization **M** points in different direction but *within a given phase,* or polymorph, or allotrope, of a *given* material. Example: the walls between the domains of closure in the usual body centered cubic (BCC) allotrope of iron (Fe). Due the effects of magnetic anisotropy, the magnetic domains illustrated in FIGURE 1 align parallel or antiparallel to an applied magnetic field **B** as shown. The difference in energy of the domains reflects the magnitude B of the *applied* field, i.e., is *extrinsic.* Such magnetic domains, separated by a magnetic domain wall, are common knowledge and disclosed in the publication the publication titled "Control of the domain wall motion in cylindrical magnetic wires", by CHIZHIK, ALEXANDER ET AL.; APPLIED PHYSICS LETTERS, AMERICAN INSTITUTE OF PHYSICS, 2 HUNTINGTON QUADRANGLE, MELVILLE, NY 11747 vol. 109, no. 5, 1 August 2016 (2016-08-01), ISSN: 0003-6951, DOI: 10.1063/1.4960605 and many other "spintronics" scientific articles and texts. Both phase and magnetic domain walls are distinct from "ferro-electric domain walls or boundaries". Examples are ferro-electric domain boundaries in the (super-) capacitor devices such as those described in the publication titled "High recoverable energy storage density and large piezoelectric response in (Bi0.5Na0.5)TiO3-PbTiO3 thin films prepared by a sol-gel method", by Li Peng et al., JOURNAL OF THE EUROPEAN CERAMIC SOCIETY, ELSEVIER, AMSTERDAM, NL, vol. 37, no. 10, 14 April 2017 (2017-04-14), pages 3319-3327, 0955-2219, DOI: 10.1016/J.JEURCERAMSOC.2017.03.024 and in the publication entitled "Large enhancement of the recoverable energy storage density and piezoelectric response in relaxor-ferroelectric capacitors by utilizing the seeding layers engineering" by XIE ZHENKUN ET AL.; APPLIED PHYSICS LETTERS, AMERICAN INSTITUTE OF PHYSICS, 2 HUNTINGTON QUADRANGLE, MELVILLE, NY 11747, vol. 106, no. 20, 18 May 2015 (2015-05-18), ISSN: 0003-6951, DOI: 10.1063/1.4921404. Such boundaries separate domains in which the electric polarization **P** points in different directions but tend to align along the direction of the electric field **E** generated by the charge on the capacitor plates. The difference in energy of different domains reflects the applied electric field and is *extrinsic.* Following the IUPAC definitions, *and common usage,* magnetic and ferro-electric domains do not constitute a separate "phase".

The word "wall" in "phase domain wall" has a precise meaning. As is common usage in Physics, see: Kittel, Charles (2005). Introduction to solid state physics (8th ed.). New York: Wiley. pg 680.ISBN 978-0-471-68057-4.OCLC 787838554 the word "wall" is used to describe a "region in space that separates two domains in which the related physical properties *are continuously and reversibly connected".* Such walls are *solitons* and cannot relax by any ordinary relaxation processes. The words "domain boundary" do *not* imply that the physical properties are continuously and reversibly connected.

It is common knowledge that it is a consequence of magnetic anisotropy that Bloch or Néel walls connect magnetic domains. In the absence an anisotropy energy, it is *unusual* that "walls" form between different ferro-electric domains. Example: The ferro-electric boundary between the domains of BiFeO$_3$ are believed to be charged and conducting whereas the bulk BiFeO$_3$ is an insulator, i.e., the material that composes the boundary is different from the bulk.

Example: The "phase boundaries" that separate (bcc) martensite and (fcc) austenite carbon steels have been studied for some centuries. "Walls" do not form because when, *through nucleation and growth,* a new phase forms as small crystallites, since it is mathematically impossible to *smoothly* connect, with a wall, the surface structure of such a crystallite with that of the surrounding old phase. Further, the different solubility of carbon in martensite and austenite steels leads to the phase boundaries having a different composition from *both* the phases connected by the boundary. Also, when the many crystallites begin to fusion their orientations are different resulting in a polycrystalline material.

The preferred embodiment of the present invention, shown in FIGURE 2, comprises a single domain, single crystal, material in which the two polymorphs can are connected by a wall. Only in special cases is this possible. Examples: A "Bain path" wall is possible between the BCC and FCC allotropes of vanadium (V) and soliton walls known to form between the phases of $VO_2$ and $Ca_2RuO_4$. single crystals.

It is the common knowledge that only when, at a given temperature, pressure and other extensive variables, the Gibbs free energies are *equal* are phase domain walls *stationary.* The equality of the Gibbs free energies directly *implies the equality of the chemical potentials,* i.e., at the equilibrium of a notional chemical reaction

$$A \rightleftharpoons B$$

the chemical potentials

$$\mu_A = \mu_B$$

are equal and the degree to which the reaction has proceeded corresponds to a "reaction co-ordinate" $\xi$. It is common knowledge that as a function of $\xi$ there is an energy barrier corresponding a transition state and implies an Arrhenius law for a *thermally* driven reaction. It is common practice to identify polymorphs A and B with such a reaction whence $\xi$ is the position of the phase wall from one end of the crystal bar in the embodiment of FIGURE 2. A knowledge of $G(p,T)$ of each phase determines their volumes $V(p,T,\xi)$ and thereby the state of charge of a phase battery. Invariably, the phase transition progresses by the transfer of electrons from one orbital to another thereby changing the direction and/or nature of the chemical bonds. The equality $\mu_A = \mu_B$ is therefore that of the *electro-chemical* potentials or simply "potentials".

It is common knowledge that if phase equilibrium corresponds to the equality of the Helmholtz free energy $A(V,T)$, there is no unique transition temperature but rather a region of temperature for which there is a co-existence of phases with many phase walls or boundaries. The latent and sensible heat are not separable, and the latent heat cannot inter-converted with electrical energy. The equality of $A(V,T)$ corresponds to a phase transition at a given *volume V.* For this reason, the embodiment illustrated in FIGURE 2 comprises free-standing single crystal.

A co-existence of phases invariable arises when, as in the publication titled "Strain effects in low-dimensional transition metal oxides" by CAO, J. et al. published on 8 January 2011 (2011-01-08), MATERIALS SCIENCE AND ENGINEERING: R: REPORTS, ELSEVIER, AMSTERDAM, NL, PAGE(S) 35 -52, ISSN: 0927-796X, stain effects occur because the volume is constrained by a substrate. The resulting multiple domains are well illustrated in Fig. 2.

It is the common knowledge that small changes in the temperature, pressure, or other extensive variables, causes a stationary domain wall to move. In prior art: K. Boukheddaden, et al., Physica B (2015), http://dx.doi.org/10.1016/i.physb.2015.09.054i (Fig. 2 and movie 1) are disclosed optical switches activated by that photoheating. It is demonstrated that a small change in temperature, from the equilibrium condition, causes a phase wall to move in a material that undergoes a high to low spin first order phase transition. Often the temperature is changed by passing an electrical current, i.e., by Joule heating. It is commonly observed that Joule heating drives phase walls, e.g., in $VO_2$ and $Ca_2RuO_4$. It is common knowledge that Joule heating is thermodynamically *irreversible,* i.e., the energy added cannot recovered. Devices based upon such heating cannot be used to store electrical energy.

It is common knowledge that, because of hysteresis, a phase transition and hence phase walls can be driven by *finite* changes of temperature from the equilibrium value. Upon superheating, $\mu_A > \mu_B$ and a phase wall will move in the direction that increases the volume of high energy phase at the expense of the low energy equivalent and the inverse upon supercooling when $\mu_A < \mu_B$. Such finite driving forces can overcome the pinning of a phase wall caused by, e.g. a non-constant cross-section or impurities.

It is common knowledge that an *essential* and *defining feature* of any "battery" (or generator) that it produces an EMF $\varepsilon$. The common language definition of an electromotive force (EMF) adopted here is "the energy per unit of charge that is imparted by an energy source, such as an electrical generator or battery. Energy is converted from one form to another in the generator or battery as the device does work on the electric charge being transferred within itself." (Encyclopaedia Britannica.) Example: The net redox reaction in a lithium-ion battery is typically represented as: $LiC_6 + CoO_2 \rightleftharpoons LiCoO_2 + C_6$; where lithium ions ($Li^+$) move from the graphite anode ($LiC_6$) to the cathode ($CoO_2$) during discharge, and then back again during charging. For a Li-ion battery the EMF $\varepsilon$ thereby corresponds to the change in the (chemical) Gibbs free energy, per electron that flows in the external circuit, measured in electron volts (eV). It is chemical and electrical energy are thereby interconverted. In a like manner, during a first order phase transition, the embodiment of FIGURE 2, interconverts lattice and electrical energy. The, EMF $\varepsilon$ *seated within the phase wall,* is equal the change in Gibbs (lattice) energy, per electron that flows in the external circuit, measured in eV. *That such an EMF occurs is a novel teaching of this description.*

It is common knowledge that the EMF of an electro-chemical cell, at a given temperature and pressure, can be calculated from the *standard electrode potentials* listed in the IUPAC "Gold Book". To within a small Nernst correction, ~50$\mu$V at ambient temperature, the equilibrium condition for a chemical reaction is mod-

ified to read

$$\mu_A = \mu_B + eV,$$

where $V$ is the voltage applied to an electro-chemical cell and $e$ the electronic charge. When the voltage $V$ of the external voltage source/load is increased so that $\mu_A < \mu_B + eV$ the reaction proceeds in the sense $B \rightarrow A$ and the inverse when the voltage is decreased. The equilibrium open circuit voltage (OCV) $V$ is equal in magnitude to the EMF $\varepsilon$. The reactions in an electro-chemical cell are invariably thermally driven with a rate constant determined by the Arrhenius law. In a similar manner a first order phase transition between polymorphs, considered as a chemical reaction:

$$A \rightleftharpoons B,$$

can be brought into equilibrium by the application of a suitable voltage

$$V = (\mu_A - \mu_B)/e.$$

In this manner polymorphs, which are *not* in equilibrium at ambient conditions, can be brough into equilibrium by the application of an external voltage applied across the terminals of embodiment FIGURE 2. The voltage $V$ *appears across the phase domain wall.* When $V > (\mu_A - \mu_B)/e$ the first order phase transition will proceed and phase wall will move thereby *charging* the phase battery while when $V < (\mu_A \mu_B)/e$ the battery will *discharge* into the load, i.e., the sense of the voltage and current are opposite. The voltage $V = (\mu_A - \mu_B)/e$ is thereby the energy difference per molecule measured in electron volts. That a phase battery is not shorted circuited reflects the topological nature of a phase wall, a Noether conserved current, and the appearance of an electro-motive force (EMF) $\varepsilon$ equal to $V$, this seated within the phase wall. *That such an EMF occurs is a novel teaching of this description.*

It is common knowledge that the difference $\mu_A - \mu_B$, and thereby the $\varepsilon$ of a phase battery, at zero absolute temperature, can be accurately estimated by the difference in the energy of formation and that these energies for many materials are given by the "The Materials Project" and found at https://next-gen.materialsproject.org. It is thereby easy to predict the energy stored by the embodiment FIGURE 2 of a phase battery.

It is common knowledge that some devices produce an EMF yet cannot be charged and/or discharged and thereby do not correspond to electrical energy storage devices. For example, primary chemical battery can only be discharged The EMF produced by the Seebeck, and photovoltage, effects cannot be used for electrical energy storage. Devices that generate an EMF by a time varying magnetic field or by motion can be used generate electrical energy but cannot function as batteries that can be charged and discharged at will.

It is common knowledge that super-capacitor can store a significant amount of energy but that the energy density is about two orders of magnitude smaller than the best electro-chemical batteries. Unlike an electro-chemical cell, and the present invention, it is common knowledge that such energy storage devices do not produce an EMF. Although different phases are mentioned, there are never two phases brought into equilibrium by an applied voltage and moving *phase domain walls,* in the devices disclosed by Peng et al. and Zhenkun et al. Rather disclosed is the movement of *ferro-electric domain walls,* and this is not in response to a transport current that flows during charge and discharge. There are no Mott, charge transfer or other electronic phase transition mentioned in the documents Peng et al. and Zhenkun et al. There are no phase transitions and no movement of phase domain walls, that occur during charge and discharge.

The "nanoionics" disclosed in document by Zhu et al., does not either explicitly or *implicitly* constitute prior art but rather a nano-scale variant of known Li-ion battery technology. They state "we propose the following mechanism: during the SET process, the electric-field driven de-intercalation of $Li^+$ ions in the LFO layer leads to the formation of conductive channels composed of $Li^+$ ion vacancies. This process simultaneously oxidizes $Fe^{2+}$ (with low-spin state 4 $\mu_B$) to $Fe^{3+}$ (with high-spin state 5 $\mu_B$)", i.e., the HRS/LRS "transition" of $\alpha$- $LiFe_5O_8$ described in Zhu et al., corresponds to standard Li-ion battery technology, on a nano-scale, and indeed it is common knowledge to those in the Li-ion battery field that $\alpha$- $LiFe_5O_8$ is a candidate cathode material for Li-ion batteries that might replace $LiCoO_2$. While *magnetic domain walls* are present, the essential ingredient of the present invention, i.e., *phase domain walls* are absent. Further, the devices disclosed in the document by Zhu et al., have the ionic current flowing *perpendicular* to the many walls whereas the present invention has the electronic current flowing *through* a single wall. As disclosed in reference 13, of this document, any energy storage device that is implicit in the document Zhu et al., would produce an EMF through the inter-conversion of chemical and electrical energy whereas the present invention inter-converts mechanical lattice and electrical energy.

In prior art, Barnes et al., WO2007015475A1 disclose a "Magnetic energy/electric energy conversion element having nano-structure" that generates a spin-motive force (SMF). Hai et al., "Electromotive force and huge magnetoresistance in magnetic tunnel junctions" Science 458, 489 (2009) disclose a tunnel junction device that has application as a "spin battery" producing an SMF. The mathematical basis for an SMF, and a spin battery, is like that for the EMF produced by a phase domain wall, and a "phase battery". The realisation of a spin battery by Hai et al., verifies this mathematical formulation.

In prior art, Barnes and Maekawa, "Generalization of Faraday's law to include nonconservative spin forces" Phys. Rev. Lett., 98, 246601 (2007), is disclosed the embodiment of an energy storage device illustrated in FIGURE 1. This device produces a *spin-motive force* (SMF), i.e., an effective EMF within a ferromagnetic material, seated in a magnetic domain wall. FIGURE 1 is a block diagram of a ferromagnetic wire having single *magnetic domain wall* which drives an SMF. The terminals 110 and 150 comprise nonmagnetic metallic materials that makes a good electrical contact to the ferromagnetic bar. In this embodiment of a "spin battery" 100, a magnetic domain wall 130 separates a region 120 of a metallic ferromagnetic material in which the magnetization points parallel to an *applied magnetic field* B and has low energy density from a region 140 where the opposite is true and for which the energy density is larger. Using permalloy as the working material, Hayashi et al., "Time-domain observation of the spin-motive force in permalloy nanowires" Phys. Rev. Lett., 108, 147202 (2012) disclose the reduction to practice of the embodiment FIGURE 1. The motion of the wall to the right, during *discharge,* produces an SMF that is balanced by a change in the chemical potential so that the right terminal 150 is negative while the terminal 110 to the left is positive. Both magnetic domains are of the same phase of the magnetic material permalloy. The wall moves in the opposite sense during *charge* when energy is provided by an external electrical energy source. When the magnetic wall separating the two regions moves in the sense that lowers the total energy, there is an SMF that maintains a potential difference, i.e., an open circuit voltage (OCV) between the terminals 110 and 150 and drives a current in the external circuit.

This prior art clearly demonstrates that the SMF developed within the magnetic domain wall is *not short circuited* when the external circuit is connected to the high and low energy domains and with the wall being part of the overall circuit. Given the same mathematical basis applies to a phase battery, this supports the present teachings that a phase domain wall produces an EMF that is *not* short circuited.

In analogy with an electro-chemical cell, it is obvious that, say during discharge, the reaction $A{\to}B$ may proceed *thermally* with a rate, i.e., phase wall velocity, given by an Arrhenius Law governed by the height of barrier reflecting the unstable structure(s) intermediate between the polymorphs $A$ and $B$. In addition. due to Galilean invariance and in analogy with a magnetic domain wall, following the prior art of Barnes and Maekawa and Hayashi et al., the reaction $A{\to}B$ may proceed, and a phase wall move *athermally* with a velocity equal to the drift velocity, $v_d$, of the charge carriers. In a Galilean reference frame moving with a velocity $v_d$, charge carriers are seen to leave or enter the left and right terminals, in the opposite sense, with a drift velocity $v_d$ and thereby causes a current to flow in an external circuit.

In the context of examples of the first order MIT transitions of $VO_2$ and $Ca_2RuO_4$ that occur a few tens of degrees above room temperature the thermal relaxation of the higher energy metallic phase cannot be ignored. This internal relaxation does not cause current to flow in an external circuit and is represented as an internal load resistance $R_p$ in *parallel* with the EMF seated in the phase wall. The mathematical justification of these observations is a novel teaching of this description.

The prior art, Barnes et al., Hai et al., Barnes and Maekawa and Hayashi et al., along with many similar works, describes devices that produce a SMF and have thereby application as energy storage devices. There is *no* explicit, or implicit, description of a data storage device in any of this prior art.

When a magnetic field B is applied, an SMF is produced between the terminals of the device disclosed as Fig. 1 in the document Chizik et al. but apparently was not measured. This device is identical in structure to the prior art of FIGURE. 1, realized earlier by Hayashi et al., and any number of workers. As disclosed by Barnes and Maekawa, there is *no short circuit* of the SMF produced by the Hayashi et al., and by the Chizik et al., devices, since the force on electrons due to the SMF, that arises in the magnetic domain wall, is exactly balanced by the gradient in the electrical potential $\mu$, i.e., $V = (\mu_A - \mu_B)/e$ is satisfied. This Physics was demonstrated by experiment and simulation in Hayashi et al. Further, it is common knowledge that there is a similar balance between the gradient of $\mu$ and an EMF that occurs at both the anode and cathode interfaces in an electro-chemical battery. The observations apply to the present invention. There is no unresolved mystery here.

An SMF corresponds to the interconversion of *magnetic* and electrical energy. Reflecting the *spontaneous broken symmetry* of a ferromagnetic material, the energy is stored can limited by the energy that can be stored in magnets. This density is characterized by the **M.H** product and is limited to less than ~$10^6 J/m^3$ for the best permanent magnets, e.g., $Nd_2Fe_{14}B$ or SmCos. This energy density is at least two orders of magnitude too small to solve the technical problem of providing an alternative energy storage technology to electro-chemical batteries such as Li-ion. The OCV ~$100\mu V$/Tesla of the Hai et al and Hayashi et al. devices is determined by the magnitude of the applied field B and is *extrinsic.* This constitutes an energy of $100\mu eV$/Tesla/atom or $500\mu eV$/atom, for a large permanent magnet field of 5T, to be compared with ~4eV/atom for a Li-ion battery.

There is prior art disclosing the propagation of phase domain walls during first order phase transitions dating back almost fifty years. For the embodiment of FIGURE 2, there is prior art B. Fischer J.Phys C: Sold St. Phys 8 2072-6 (1975I) that establishes that phase domain walls associated with the MIT transition of $VO_2$ can be driven *thermally* by an electrical transport current through a combination of Joule heating and Peltier heating/cooling. It is common knowledge that, at low temperature, $VO_2$ assumes a monoclinic M1 insulating phase. At a critical temperature $T_c \approx 340K$ it undergoes a reversible first order phase transition to a high temperature metallic rutile R phase with an appreciable latent heat. Due to its higher resistance, at ambient temperature and pressure, a current $I$ causes a Joule heating $I^2R$ that lifts the temperature above $T_c$ and a transition to the metallic phase occurs. However, for the same current, and the metallic phase, Joule heating $I^2R$ is too small to maintain the temperature $T > T_c$. As a result, the transition occurs with the propagation of a phase domain wall. However independent of the sense of the current, the phase domain wall should be initiated at the end of bar of material with the highest resistance. Due to the different reflectivity of the metal and insulator phases the propagation of the phase wall can be followed with an optical microscope and it is found that the phase wall propagates rather in the same sense as the current. B. Fischer J.Phys C: Sold St. Phys 8 2072-6 (1975II) discloses that this results from Peltier heating/cooling at the phase wall. Associated with the Peltier effect is an EMF due to the Seebeck effect. Although no data to that effect is shown, it is implicit, that due to an inevitable temperature gradient, such a device *might* function as a heat engine converting heat into electrical energy, whereas the present invention converts stored lattice to electrical energy and will function at very low temperatures where the Seebeck effect is absent. While this prior art establishes the possibility of the propagation of a phase domain wall during a first order phase transition it does not constitute prior art to the present invention since the implicit heat engines cannot be charged and discharged with electrical energy.

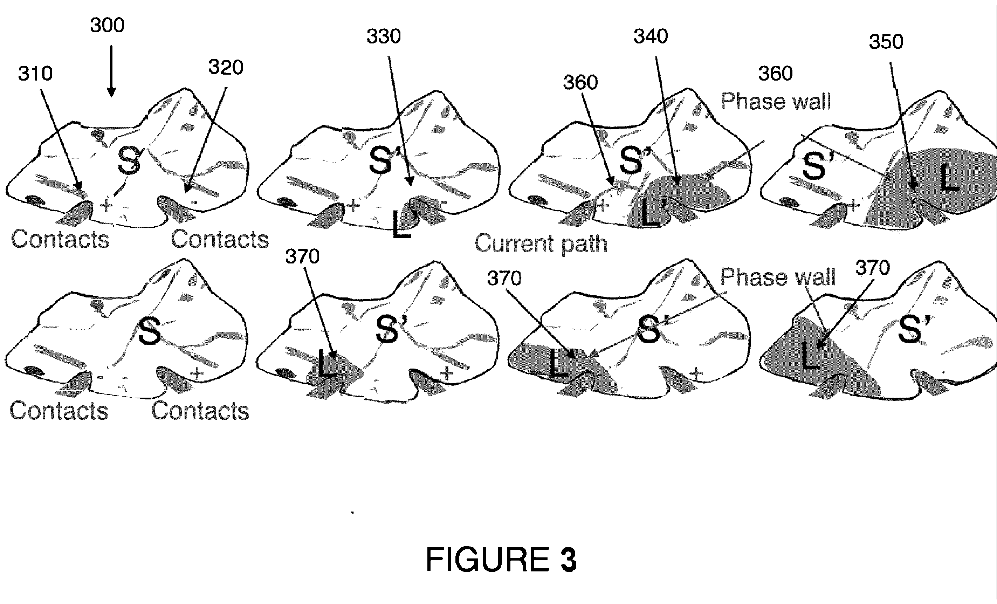

There is more recent prior art also disclosing the *thermal* propagation of phase domain walls during first order phase transitions. The embodiment FIGURE 2, on a nanoscale, for slightly W doped $VO_2$, is disclosed in ref. [186] of the document by Cao et al., i.e., Q. Gu, A Falk, J. Wu, L. Ouyang, H. Park: "Current-Driven Phase Oscillation and Domain-Wall Propagation in WxV1-xO2 Nanobeams" Nano Lett 10 2003-2011 (2007), see Fig. 1a (insert) and Fig., 3c. Similar to undoped $VO_2$, the lower energy $S$ phase is insulating $W_xV_{1-x}O_2$ while the higher energy equivalent is the metallic $L$ phase of $W_xV_{1-x}O_2$. The high quality single-crystalline $W_xV_{1-x}O_2$ nanobeams are synthesized the vapor transport method. It is emphasized By Gu et al. that free standing beams, as in FIGURE 2, are important to avoid the formation of multiple phase walls due to strains. This is the subject of document by Cao et al. Such devices exhibit a dynamical negative resistance and due to a parallel capacitance function as oscillators up to 5MHz. Following Fischer (1975II) it is disclosed that the oscillations occur "through the axial drift of a single M-I domain wall caused by Joule heating, (and) the Peltier effect, the MIT, (and) heat dissipation". Implicit is a Seebeck effect EMF associated with the Peltier effect, i.e., the device *might* function as a heat engine although no data to this effect is presented. The Seebeck effect, corresponding to the *irreversible* conversion of heat into electrical energy. No energy storage device is disclosed or implied as is evidenced by the fact that the current and voltage in Fig. 2b and Fig. 3a and b are always in the same positive sense whereas, as is common knowledge, that during discharge of a battery the current and voltage are of an opposite sense.

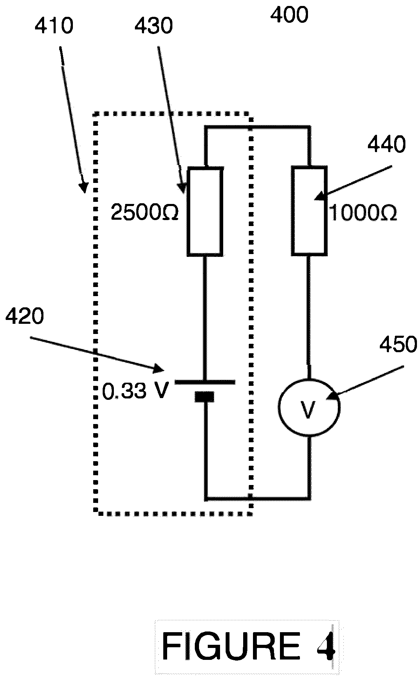

There is published supplementary data that demonstrates the *athermal* propagation of phase domain walls during the first order MIT transition of $Ca_2RuO_4$. The data of J. Zhang et al., (15 Feb 2019) "Nano-Resolved Current-Induced Insulator-Metal Transition in the Mott Insulator Ca2RuO4" Phys. Rev. X 9 011032 is reproduced in FIGURE 3. Their work "confirms that the electrically induced metallic phase is non-filamentary and is *not* driven by Joule heating". The material $Ca_2RuO_4$ is an analog of $VO_2$ with a MIT transition with a $T_c \approx 357K$. It is clear from FIGURE 3 (Figs. 1(b) and (c) of Zhang et al.) that the device is *not* a simple bar as in the embodiment FIGURE 2 of this description and consequently the surface tension of the phase domain wall must be considered in the condition $\mu_L + t = \mu_{S'} + eV$, where $t$ reflects this tension. At temperatures below $T_c$, when $V > (\mu_L - \mu_{S'} + t)/e$, *beginning always from the negative contact,* the first order phase transition $S' \rightleftharpoons L$ proceeds by the displacement of a phase wall between $S'$ low energy semi-metal phase (in white) and the high energy metallic phase (in red) and corresponding to the "charging" of the device. The phase wall moves in the direction of electron motion as occurs in Hayashi et al. for magnetic domain wall. As is common knowledge, the surface tension t decreases with increasing volume and hence, as is shown Fig. 1(a) of Zhang et al., the equilibrium condition $\mu_L + t = \mu_{S'} + eV$ occurs with decreasing voltage $V$ as the high energy $L$ phase grows. While Joule heating plays a minor role, thermal relaxation and the equivalent parallel resistance $R_p$ are important. The naively $R_p$ is inversely proportional to the area of the phase wall and decreases rapidly with the increase of the volume of the high energy phase $L$. It follows that the athermal current at the equilibrium condition $\mu_L + t = \mu_{S'} + eV$ must increase strongly to compensate for the thermal relaxation, as seen in Fig. 1(a) and (c) of Zhang et al. Under the conditions realized in this experiment the battery that constitutes the phase wall discharges into $R_p$ and not the external circuit. This is illustrated in Fig. 4d of Zhang et al. When the applied bias is slightly reduced from the equilibrium value the athermal current is no long large enough to compensate for the $R_p$ thermal current and phase wall moves to reduce the volume of high energy phase $L$. Consider the irregular $Ca_2RuO_4$ sample [300] of FIGURE 3, of with positive [310] and negative [320] terminal. The sample is initially in the insulating phase $S$. Above an critical voltage described herein the $L$ phase forms [340] always about the negative terminal. As the voltage increases the L phase [340] increases in volume until [350] it occupies a large part of the sample. There is an EMF [360] seated at the domain wall indicated by the battery symbol. When the voltage bias is reversed the high energy phase $L$ [370] expands, as before, from the negative terminal. This illustrates the athermal charge/discharge of a "phase battery".

The published supplementary data of Zhang et al., also discloses the existence of *two distinct phase* transitions caused by an applied voltage V. Below a threshold voltage $V_{th}$~5.5V $Ca_2RuO_4$ assumes the insulating monoclinic M1 phase (labelled *S*) with an activated conductivity reflecting a gap known to be ~0.2eV. At $V_{th}$ occurs an electric field driven transition to a monoclinic semi-metal phase labelled S'. The phase wall of FIGURE 3 (Figs. 1(b) and (c) of Zhang et al.) separates the *S'* from the high temperature higher energy rutile phase (labelled *L*). The supplementary data of Zhang et al., illustrates the basic elements of a phase battery but fails to show the discharge of such a device into an *external* load.

In prior art Nakamura, F. et al. "Electric-field-induced metal maintained by current of the Mott insulator Ca2RuO4". Sci. Rep. 3, 2536; DOI:10.1038/srep02536 (2013) have disclosed that $V_{th}=V_0\exp(-T/T_0)$ for the characteristic of depinning voltage of Peierls MIT transition. However once established, the *S'* phase persists to currents several times smaller than that following the forward $S \rightarrow S'$ transition. (As for stick/slip friction.) It follows the transition $S \rightarrow S'$ always occurs before the applied voltage falls to the equilibrium value $V=(\mu_A-\mu_B)/e$ and hence before the device would discharge into the *external* load. Rather the device discharges into the internal resistance $R_p$. To avoid this, it is imperative to increase $R_p$. by increasing the barrier for *thermal* relaxation. This is accomplished by increasing coherence of the Peierls state. Since this will also increase the Peierls gap and thereby increase the resistance in the *S* phase. The desired increase in the thermal barrier will also increase the thermal hysteresis. Samples should exhibit larger resistance change between the *S* and *L* phases and a large thermal hysteresis.

Supplementary data to this effect is found in the master's thesis (14/08/2020) of J. A. Cornejo Jimenez (DCJ) (supervised by S. Karg of IBM Zurich) "Study of the fabrication of VO2 devices for application on Oscillatory Neural Networks" and published at: https://webthesis. biblio.polito.it/16023/1/tesi.pdf. Disclosed in Figs. 45 and 46 is a device that has a large resistance change between the semi-conducting *monoclinic* M1 and metallic *rutile R* phases and a large thermal hysteresis indicative of coherent phase wall dynamics. Although it was designed for a different purpose, the device acts as a phase battery, i.e., can be discharged into an external load. In Fig. 45 shown is the resistance as function of temperature. This exhibits large, order $10^3$, single step resistance ratio changes and a large thermal hysteresis of more than 50K. In Fig. 46a is show the voltage driven IV-characteristic. The load lines reflect an external series resistance of 1kΩ. A transition to a *monoclinic* semi-metal phase MM (the equivalent of the *S'* phase for $Ca_2RuO_4$) occurs at a threshold voltage $V_{th} \approx$1.4V. Since the fully metallic rutile phase R has a much smaller resistance than the MM phase, the state of the first order phase transition MM→R is manifest as a decreasing (internal) resistance. The extrapolated transition curve MM→R determines an EMF $\varepsilon \approx$0.35Volts. Below a current I≈0.38mA the current is too small to maintain the MM phase and the transition MM→M1 occurs on a load-line terminating at a voltage V≈0.7Volts and a positive current. The discharge, i.e., a change in sign of the current $I$ begins at an open circuit voltage $V_0$ consistent with $\varepsilon$ ≈0.35Volts and the V=0 current I≈0.1mA corresponds to a load resistance R≈3.5kΩ. Thermal relaxation and the associated $R_p$ is negligible. FIGURE 4 shows the effective circuit during discharge. The large internal resistance R≈2.5kΩ implies only about 1/3 of the stored energy is delivered to the *external* load. Nevertheless, this supplementary data *establishes the principle of a phase battery* albeit on a sub-μm scale. The energy density, reflecting an $\varepsilon \approx$0.35Volts and the lattice parameters of $VO_2$, is roughly 1x10^9J/m^3 and about 1/3 of the *best* Li-ion electro-chemical cells and comparable to Pb-acid. In FIGURE 4, [400} is shown the effective circuit of the "phase battery". The dotted line [410] indicates the physical extent of the battery element. The battery symbol [420] indicates an EMF of 0.33Volts. There is [430] a large internal resistance of 2.5kΩ [430]. The load resistance {440} is 1.0kΩ and external source/load [450] has a voltage V.

In order that a skilled person might unequivocally understand the manner in which the current invention might be charged and discharged without a "short circuit", and thereby realize the embodiment of FIGURE 2 with a suitable working material, it is necessary to understand the teachings about "emergent electromagnetism" that have emerged in the last decade or so and the new Physics teachings that is contained in this description. A rather dated description of emergent electromagnetism is found in Nagaosa and Tokura, "Emergent electromagnetism in solids" Phys. Scr. 014020 (2012). The application to the SMF seated in magnetic domain walls is found in Barnes and Maekawa op. cit., and for the EMF seated in a phase domain wall, in what follows. Particularly relevant to the concept of an emergent SMF and EMF is the generalization of the usual vector potential $\vec{A}$ first introduced in M.V. Berry, "Quantal Phase Factors Accompanying Adiabatic Changes." Proc. Royal Soc.A 392, 45-57 (1984); https://doi.org/10.1098/rspa.1984.0023 and in the context of an SMF by Barnes and Maekawa op. cit. Following the work of Berry it is widely recognized that the tradition Born-Oppenheimer approximation (Born and Oppenheimer "Zur Quanten theorie der Molekein" Annalen der Physik 389 457-484 (1927)) does not fully describe the interactions of electrons with the lattice. The teachings contained herein demonstrate that this approximation completely misses the EMF central to the present invention. Further, the skilled person must be familiar with topology as it applies to phase domain walls. These are *distant technical fields* from that of the currently dominant electro-chemical energy storage technology and corresponds to a skill set found only in *teams* of researchers at topflight universities, national laboratories and a few industrial enterprises. This is a new "blue sky" technical field with no real direct prior art.

It is common knowledge that the various forces in Nature, electromagnetic, weak and strong interactions (and maybe gravity) reflect gauge groups U(1), SU(2) and SU(3) with their associated Lie algebra. "Emergent electromagnetism" recognizes that new emergent forces reflect a solid-state broken symmetry with its associated gauge group. Traditional electromagnetism corresponds to U(1), and the Berry connection is the regular vector potential $\vec{A}$. Magnetism has broken time reversal symmetry, a gauge group SU(2), a Barnes-Maekawa-Berry connection $\vec{A}_s$, and an SMF. New in the context of the present invention is the different broken translational symmetry that reflects the various polymorphs of the solid state of some working material. The gauge group is U(1), there is a new Berry connection $\vec{A}_m$ that leads to the mechanical EMF and an energy storage device. It is essential that the skilled team of persons that would reproduce the present invention understand and can apply these basic principles.

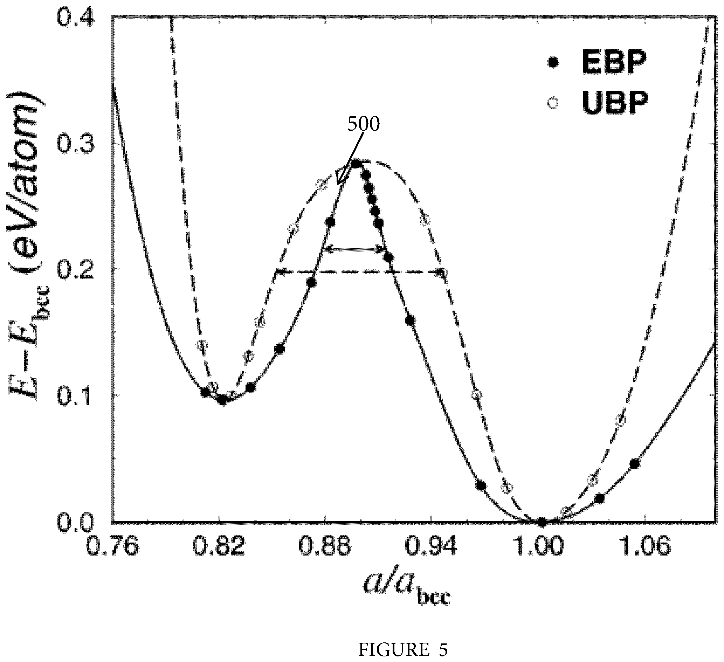

It is common knowledge that the chemical reactions $A \rightleftharpoons B$ in electro-chemical batteries involve ionic transport, e.g. of $Li^+$ ions, and therefore the voltage $V$ biased equilibrium condition $\mu_A = \mu_B + eV$ involves ionic chemical potentials $\mu_A$ and $\mu_B$. In contrast for first order polymorphic phase transitions, viewed a reaction $A \rightleftharpoons B$, involve the transfer of electrons between different orbitals and the same equilibrium condition involves the electro-chemical potentials $\mu_A$ and $\mu_B$. usually denoted by e.g., $\mu_A = qV_A$, i.e. the product of the electronic charge $q = -|e|$ and the electrical potential $V_A$. The equilibrium condition with a bias $V$ is thereby simply $V_A = V_B + V$, i.e., the external open circuit voltage is simply equal to the difference in the electrical potential of the two polymorphs, except of course in the region of the phase wall where the EMF is seated. The polymorph reaction $A \rightleftharpoons B$ passes by some intermediate lattice structure of higher energy. FIGURE 5 is an example of the reaction coordinate $\zeta$ as a function of lattice distortion at zero temperature. The energy barrier between the states $A$ and B implies the phase wall costs a considerable energy and implies coherent dynamics. This barrier is also that for *thermal*" over the barrier" relaxation of the high energy polymorph corresponding to a $R_p$. A barrier height significantly greater than the thermal energy $k_B T$ is needed to avoid the rapid thermal self-discharge of a phase battery. An applied electric field that satisfies $V = (\mu_A - \mu_B)/e$ tilts FIGURE 5 in such a manner that the two local minima have the same energy. The associated real space potential is defined as $V_0(\vec{r})$.

With this common knowledge background, without a complicated mathematical formalism, it is possible to understand the origin of mechanical Berry connection, $\vec{A}_m$ and the EMF this produces. This is at the heart of the invention described herein. It is common knowledge from, e.g., the quantum mechanics of a hydrogen atom, that the problem separates in the description of the center of mass and relative co-ordinates. In this scheme, and the Born-Oppenheimer approximation, the rapid "electronic" degree of freedom corresponds to the relative co-ordinate while the slow "ionic" degree is that of the center of mass. The electron is no longer a "bare" electron but rather a quasi-particle the motion of which is entangled with that of the ion, i.e., the proton in this precise case. In like manner in a crystalline solid the electronic degree of freedom corresponds to the motion *relative* to background lattice. It follows the velocity of a "bare" electron is that $\vec{v}$ of the quasi-particle minus $\vec{V}$ the velocity of the lattice. Usually the bare U(1) gauge invariant electron momentum is $m\vec{v} = \vec{p} - e\vec{A}$ where $\vec{p}$ is the canonical momentum and $\vec{A}$ the usual U(1) vector potential. Accounting for the lattice velocity, the U(1) gauge invariant electronic momentum now reads $m\vec{v} = \vec{p} - e(\vec{A} + \vec{A}_m)$ in which $e\vec{A}_m = \frac{m}{M+m}\vec{P}$ where $\vec{P}$ is the momentum, and M the mass, per atom of the background lattice. The properly executed Born-Oppenheimer approximation requires that the net force on a *bare* electron wave-packet be zero, i.e., the wave-function of such electrons obeys a time independent Schrödinger equation. It is thereby required that the net emergent electric field seen by a wave packet $\vec{E} = -\frac{\partial \vec{A}_m}{\partial t} - \vec{\nabla} V_0 = 0$ where $V_0$ is the smoothly varying potential defined above. (The regular vector potential $\vec{A} = 0$.) This reduces to an equation for the force $\vec{F} = \frac{d\vec{P}}{dt}$ *acting upon the ions.* In the Born-Oppenheimer approximation, as an electron wave-packet passes through the phase wall the ions, described by semi-classical equations of motion, displace in such a manner that the total force $-\frac{\partial \vec{A}_m}{\partial t} - \vec{\nabla} V_0 = 0$. When the wave-packet lies outside the phase wall $\frac{\partial \vec{A}_m}{\partial t} = 0$. Then that $\vec{\nabla} V_0 = 0$ is equivalent to equilibrium requirement $V = (\mu_A - \mu_B)/e$, i.e., that the A and B wells have equal depth.

For near equilibrium when $V > (\mu_A - \mu_B)/e$ the emergent electric field $\vec{E} = -\frac{\partial \vec{A}_m}{\partial t} - \vec{\nabla} V_0$ is no longer exactly zero and causes bare electron wave-packets to have a net drift velocity $v_d$. In turn this leads a domain wall center of mass velocity $V = v_d$ confirming the Galilean invariance. The finite domain wall velocity $v_d$ corresponds to a current that athermally drives the *first* order phase transition thereby *charging* the phase battery. When $V < (\mu_A - \mu_B)/e$ the emergent electric field has the opposite sense driving wave-packets and current in the opposite sense to the applied voltage leading to a *dis-*

*charge* into the load. That a current athermally drives a phase wall with a velocity $v_d$ is easily verified to be simple consequence of the conservation of energy given an EMF $\varepsilon = (\mu_A - \mu_B)/e$. The principal results, that the phase wall velocity be *va the* drift velocity of the electrons and an EMF $\varepsilon = (\mu_A - \mu_B)/e$ are direct consequences of Faraday's Law and the theory of emergent electromagnetic gauge theories. While this application is new, the theory is well established. It is found the EMF is seated in the phase wall and is *not* "short circuited" in the embodiment of FIGURE 2 of a phase battery. This is essential guidance for skilled team of persons that would reproduce this embodiment of the present invention.

The present technology includes working materials having different structural or chemical phases. Many materials such as water exist in more than a single phase, for this example ice, liquid water and steam that can exist together as pairs, e.g., water and ice, or as all three at the triple point. For a first order phase transition, such as that between water and steam, even when they have the same temperature, there is a difference in free energy between the pair of phases, here steam and water, that for equilibrium thermodynamics corresponds to the latent heat of transformation. Steam is dangerous and can burn the skin, not so much because it is hot but because of its latent heat. Because the electrical conductivity of water and steam (or ice) are different at a given temperature, when e.g., an ice/water interface moves, due to say a slight change in the external pressure, there will be produced a non-conservative, i.e., motive force that can cause a current to flow in an external circuit. While not a practical device, this illustrates the concept of first order phase transition batteries.

FIGURE 2 is a diagram of the basic embodiment of the invention described herein. This embodiment of a "phase transition battery" 200 consists of a single piece of working material that makes a good electrical contact to metallic terminals 210 and 250. Two phases of the working material - a first phase associated with portion 220 and a second phase associated with portion 240 - are separated by a phase wall 230. In passing through the phase wall, a crystal structure evolves smoothly from one structure in the first portion to the structure in the second portion. The structure is identical to that of the prior art FIGURE 1 with the high and low energy phases replaced by magnetic domains and with a phase domain wall replacing a magnetic domain wall. As in the prior art Hayashi et al., op. cit. the motive force seated in the wall maintains an open circuit voltage that is not internally short circuited.

For this preferred embodiment of the invention, FIGURE 2, illustrates a "phase transition battery" 200, compring of a slab of the working material, i.e., the substance that stores the energy, with contacts 210 and 250 at each end. The portion 220 near one contact 210 is in the lower energy phase (phase 1) while portion 240 having a different phase (phase 2) of higher energy is near the second contact 250. The two phases are separated by a phase-wall, through which one phase deforms *smoothly* and *reversibly* into the other. It is emphasized that the two-phase regions, and the phase wall, are all made of the same material.

An illustrative is the metal vanadium (V) for which the lower energy state has the body-centered cubic "1" phase (bcc) and with a tetragonal higher energy "2" phase. Within the domain wall, one phase is continuously deformed into the other following an energy minimum Bain path described by a single (lattice) parameter *a*. (The reaction co-ordinate.) In Alippi et al., "Strained tetragonal states and Bain paths in metals" Phys. Rev. Lett. 78, 3892 (1997), the energy is calculated as a function of *a* as shown in FIGURE 5. FIGURE 5 illustrates a graph 500 that plots the energy E, minus the value for the bcc structure, in eV/atom along possible Bain paths

For vanadium, the difference in energy between the two phases is about 100meV/atom This is reflected by a terminal voltage of about 0.1V. The large barrier height of 200 meV between the locally stable minima at $a = a_0$ and $a \approx 0.82 a_0$ assures that the thermally activated classical relaxation, is negligible when the battery is operating near room temperature. The energy density of $1.6 \times 10^{-20} J/[(2:93)^3 \times 10^{-30}] \approx 6 \times 10^8 J/m^3$ or with a mass density of 6,000 kg/m$^3$ about 0.1 MJ/kg comparable to a Pb-acid battery at 0.17 MJ/kg. Most simple metals have different polymorphs, e.g., Sn, Ti, Fe, Co, Ni etc., and their alloys, and might be used as a working material. Because of the smallish energies involved, in the and other embodiments of the current invention, the material must be extremely pure and crystalline to avoid pinning of the phase wall.

It is common knowledge developed over hundreds of years that only a very limited number of crystal structure *reversibility* transform into each other. The Materials Project opt cit., reports the energy of all known such structures in addition to many hypothetical structures. (Along with their topological nature.)

Phase transitions between insulating (or semiconductor) and metallic phases can also be used as embodiments of the current invention. Illustrative examples are $VO_2$ and $V_2O_3$ and more generally the Wadsley $M_nO_{2n+1}$ and Magnéli phases $M_nO_{2n-1}$, where n is an integer, and where M is a 3d 4d or 5d transition metal, e.g., V,Ti,Mo,Nb or Fe that easily assume more than one valence. Invariably a first order metal to insulator transition (MIT) involves a change in the lattice parameters and/or structure.

It is relevant to the present invention that all solids have broken translational symmetry and that many have different polymorphs, i.e., different materials with a given chemical formula. For example, $Fe_2O_3$, can occur in different crystal structures, such as rhombohedral, cubic, cubic body-centered, and so on, for this example. It is also important that certain crystal growth techniques, e.g., pulsed laser deposition (PLD), with suitable growth conditions and substrates, can be used to grow such polymorphs at will. Of the four commonly recognised insulating crystalline phases of this iron (III) oxide: $\alpha$-$Fe_2O_3$ (hematite), $\beta$-$Fe_2O_3$, $\gamma$-$Fe_2O_3$ (maghemite), and $\varepsilon$-$Fe_2O_3$, hematite is found in nature, while $\alpha$-$Fe_2O_3$, $\gamma$-$Fe_2O_3$, and $\varepsilon$-$Fe_2O_3$, along with the conducting mixed valent $F_3O_4$, can be grown, e.g., using PLD and similar techniques.

It is an important ingredient in the design of a working material that the physical size of an atom depends upon is spin and charge state, along with its atomic coordination, e.g., Ti with six-fold coordinate has ionic radii of 0.86, 0.67 and 0.61 Å for the charge state +2, +3 and +4 respectively. Similarly, with the same coordination +2 Fe has high spin (HS) and low spin radii of 0.78 and 0.61Å while for +3 Fe these are 0.65 and 0.55Å and HS +3 has a larger ionic radius 0.65Å that LS +2 Fe with radius 0.61Å.

A phase battery based upon elemental Fe (and Fe:Ni alloys) as the working material might complete with Pb-acid. Many other 3d metals, e.g., Mn Co and Ni, and/or simple alloys also show the HS/LS effect and are also potential working materials. HS/LS transitions also occur in 4d and 5d metals and alloys, and these also constitute potential working materials.

These different phases have a different energy associated with the order parameter that, for the example, implies the rhombohedral $\alpha$-$Fe_2O_3$ is the ground state, i.e., has the lowest energy at ambient pressure. Under high pressure yet another polymorph, h-$Fe_2O_3$ with a different energy, appears in which the $Fe^{3+}$ ions undergo a transition from high spin (HS) to low spin (LS).

Magnetite, $Fe_3O_4$, contains both $Fe^{2+}$ and $Fe^{3+}$ ions and is conducting at ambient conditions. Calculations show this undergoes a ~10% volume change, at a critical pressure $P_c$ ~30GPa, implying an energy density of ~ $3 \times 10^9$ J/$m^3$ associated with a HS to LS transition. This pressure is such that the work done by the volume change is equal to the difference in energy density between the polymorphs. When charging a battery an electrical pressure replaces the mechanical pressure and the HS to LS transition can be induced by applying a voltage difference across the phase wall. When the battery discharges the same voltage difference, across the wall, is maintained by the EMF generated within the wall, i.e., the near stationary wall separates the low energy HS $\alpha$-$Fe_3O_4$ from the high energy LS h-$Fe_3O_4$ usually only found at high pressure. This same principle extends to the examples detailed below. The high to low spin transition, with or without an ionic charge transfer, is a possible ingredient in the design of the working material. For example, elemental Fe in the face centered cubic structure (fcc) has an energy that is smaller by ~150meV for the LS than for the HS equivalent.

Elemental Fe assumes a HS body centered cubic (bcc) structure but is stabilized as fcc in Fe-Ni alloys. Such an alloy with ≈30% of Ni, known as "Invar", is important technically due to its very small coefficient of thermal expansion. This reflects the small ionic size of the LS state that is almost degenerate with the HS equivalent at this composition. The volume is ~3-5% lower in the LS phase. Between 0-40% Ni such alloys exist in two phases, i.e., anti-taenite and taenite, and constitute minerals that have the same fcc crystal structure and same chemical composition (same proportions of Fe and Ni) but differ in their electronic structures: taenite has a high magnetic moment (HS) whereas anti-taenite has a low magnetic moment (LS).

Some such alloys, e.g., FeRh undergo first order transition between a higher energy ferromagnetic metal (FM) and an antiferromagnetic metal (AFM) with a structural phase transition and a volume change of about 1%. The energy density associated with the magnetic exchange energy is different for the two materials and this contributes to the electrical energy that can be stored. The terminal voltage a battery working with FeRh will have a terminal voltage of about 0.1 - 0.2V but other materials have potentially larger contributions reflecting larger internal exchange fields and larger volume changes.

The so called "shape memory alloys" undergo a martensite-austenite phase transformation. According to calculation, the Heusler composition $Ni_2CoAl$ has a more than adequate barrier height of 0.5 eV and a predicted terminal voltage of ≈ 0.22V and a correspondingly higher energy density than the elemental metals. Similarly, the half Heusler $Ni_2CoB$ would produce a terminal voltage of 0.35V. Of the half-Heusler alloys, LiMnN has $\alpha$ and $\beta$ polymorphs that differ in energy by over 2 eV. Heusler intermetallic compounds with a 1:1:1 composition (often called Half-Heusler) or 2:1:1 composition comprises more than 1500 members of which many have different polymorphs and might serve as working materials.

The Wurtzite ABC compounds have a significant energy difference between the ideal $P6_3mc$ and distorted $P6_3mmc$ polar space groups. For the example LiZnSb, calculation gives a difference of ≈1.0eV between these structures and, while the Wurtzite structure is unstable, it is implied that similar materials of this structure would have a terminal voltage of about 1V. These Wurtzite ABC compounds can be classed as combinations into the following groups: I-III-IV (e.g. LiGaGe), I-II-V (e.g. LiBeSb), I-XII-V (e.g. LiZnSb), XI-III-IV (e.g. CuYSn), XI-II-V (e.g. AgCaBi), and II-XII-IV (e.g. CaZnSn). Many have been fabricated with many more being potential candidate working materials.

Perovskites oxides have the formula $ABO_3$, e.g., the ferrite $LaFeO_3$ for which the formal valences are $La^{3+}$, $Fe^{3+}$ and $O^{2-}$. In such simple oxides the A-element is the larger of the two ions. Typically, the A ion is La, Sc, Sm, Ce, Er, Gd, Ho, Nd, Pr, Tb, Tm, Y, Lu, Bi, Dy, while the B ion might be taken from Cr, Fe, V, Mn, Ti, Ni, Al, or Ga. More generally, the sum of the valence of the A and B ions must be six. Also, A might be a monovalent Li, Ag K, Na, Cs, Tl, Rb while B would be Nb, Ta, U W, V, I, Sb Bi and for divalent A ions, Ba, Ca, Sr, Ba, Pb with B being V, Hf, Ma, Ru, Sn, Ce Ru, Zr, Mo, U, Th, Ti, Pr, Pb, or Mn. Perovskites exist in which oxygen is replaced by F, e.g,

KMnF$_3$, KFeF$_3$, KCoF$_3$, KNiF$_3$, KCuF$_3$ or by Cl, Br I, Si, etc. Organic perovskites e.g., CH$_3$NH$_3$SnI$_3$ also exist along with mixed cations and anions. More complicated are the layered perovskites that consist of two-dimensional perovskite slabs interleaved with cations or cationic structural units. The Dion-Jacobson series of layered perovskites, A'[A$_{n-1}$BnO$_{3n+1}$], typified by the n = 3 phase CsCa$_2$Nb$_3$O$_{10}$ which has one interlayer cation per formula unit. Ruddlesden-Popper phases, $A'_2$ [A$_{n-2}$BnO$_{3n+1}$], such as K$_2$La$_2$Ti$_3$O$_{10}$, have two interlayer cations per formula unit and possess twice the interlayer charge density of the Dion-Jacobson phases.

Aurivillius phases, including Bi$_2$W$_2$O$_9$ are intergrowths of perovskite and bismuth oxide and have a covalent network of $Bi_2O_2^{(2+)}$. Many such combinations are potential working materials that can be grow by several methods well known to those versed in the art.

For a simple Peierls MIT transition there is one or more periodic distortions of the lattice such that a gap opens at the Fermi level of an otherwise metallic material, creating a charge density wave (CDW). Such a CDW and the related spin density wave (SDW) are often (weakly) first order. When such distortions are commensurate with the existing lattice, this amounts to a transition between two polymorphs with a different unit cell size. Despite the gapped Fermi surface, when rather the distortion is incommensurate with the underlying lattice, the CDW/SDW will slide leading to Frohlich conductivity. Working materials based upon incommensurate Peierls/Frohlich transitions are possible in which conduction is by the Frohlich mechanism in the gapped phase. Currently known examples of CDW/SDWs such as K$_{0.3}$MoO$_3$ or NbSe$_3$, etc., have rather low energy densities. Because of pinning Frohlich conduction only occurs above a certain threshold electric field and is resistive.

Superconductors, in common with a CDW/SDW, usually, also have a gaped Fermi surface and have conduction electron current is proportional to the U(1) connection $\vec{A}(\vec{r},\ t)$. Below a first order superconductive transition temperature $T_c$ a superconductor/metal phase wall produces an EMF. However most such transitions are, at best, weakly first order and the energy density for known superconductors is rather small.

Mott-Hubbard metal-insulator transitions usually occur between a higher energy paramagnetic metallic phase and a lower energy insulating anti-ferromagnetic or ferromagnetic phase. Such transitions reflect a competition between the kinetic energy of electrons in the metallic phase with the Coulomb and Hund's rule correlation energies and crystal field energies of the magnetic insulating phase. The Hund's rule energy is smaller in the LS state and often a HS to LS transition is associated with a Mott-Hubbard transition. Since the LS ionic radius is smaller, and by extension the radius in the same ion in the metallic state (different from the "metallic radius"), than the HS equivalent this transition is often first order and associated with a polymorphic transition. In the illustrative examples M$_{2n}$O$_{2n\pm1}$, Mott-Hubbard and Peierls like transitions are mixed and compete. The half-filled magnetic 3d$^5$ configuration has a particularly large Hund's rule correlation energy as compared to 3d$^4$ and 3d$^6$ and Mott-Hubbard transitions can also drive, or be driven by, charge transfer between ions, a feature of particular interest for battery designs.

The semi-conducting phase of VO$_2$ might be made metallic by doping holes into the oxygen valence band. The Wadsley phases M$_n$O$_{2n+1}$, e.g. V$_6$O$_{13}$ have V with formal V charge greater than +4. This high valence state is identified with a hole in the oxygen band and might be expected to be a conductor in its ground state. In fact, V$_6$O$_{13}$ has an insulating ground state and undergoes an insulator to metal transition at ~ 150 K. The crystal structure adjusts so there is a periodic charge on the V atoms. There are two sites with nominal charges of 4+ and a single site with 5+ and a gap opens at the Fermi energy. Similarly, the Magnéli phases M$_n$O$_{2n-1}$ might be expected to be electron doped and be metallic. In fact, e.g., V$_3$O$_5$ has a formal V valence of 5/3 but has an insulting ground state with an insulator to metal transition at 430K. The lattice structure accommodates V$^{3+}$ and V$^{4+}$ in an ordered manner. The oxide V$_7$O$_{13}$ remains metallic to the lowest temperatures but undergoes a transition from an anti-ferromagnetic to paramagnetic metal at about 40K. To the extent that this transition of (weakly) first order this magnetic transition might be used as an embodiment of the present invention. Hydrogenation to H$_{0.64}$VO$_2$ does leads to metallization of low temperature monoclinic phase of VO$_2$ and the transition to rutile phase might also be used as an embodiment of the present invention.

Rust, $\alpha$-Fe$_2$O$_3$, at the stoichiometric composition is an insulator with the nominal valence Fe$^{3+}$, but at $\approx$60 GPa undergoes a first order transition to a metal with, at least, a partial HS to LS transition and a volume change of $\approx$ 10%. The volume change implies a more than adequate energy density of $\approx$ 5 x 10$^9$ J/m$^3$. It is this energy, associated with a transition from HS to LS is exploited in the metal-to-metal transitions of LaCu$_3$Fe$_4$O$_{12-x}$ and LaBi$_2$AlFe$_2$O$_{9-x}$, but many other possibilities exist and other ions such as Mn, Co and Ni along with 4d and 5d elements can undergo such spin transitions.

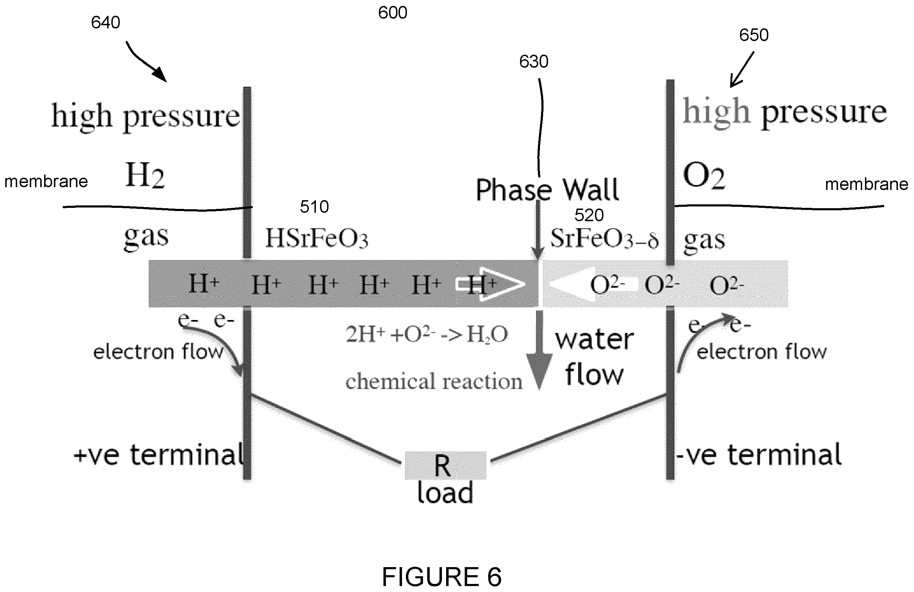

FIGURE 6 illustrates a schematic a phase transition battery based upon different chemical phases. In the illustrative example of FIGURE 6, to one side of the phase wall 630 is a n-type electrical conductor corresponding to hydrogen intercalated H$_y$La$_{1-x}$Sr$_x$FeO$_{3-x/2}$ 610 while to the other side is the same material La$_{1-x}$Sr$_x$FeO$_{3-y}$ 620 doped with oxygen. At the wall, the reaction 2H$^+$+O$^{2-}$ $\leftrightarrow$ H$_2$O occurs resulting in insulating La$_{1-x}$Sr$_x$FeO$_{3-x/2}$ with intercalated neutral H$_2$O. Since water expands the perovskite lattice and since the positive LaO and negative FeO$_2$ layers are subject to a strong, order 100GPa, compressive force the H$_2$O is ejected

through the surface of the working material, this consistent with the fact that $LaFeO_3$ does not hydrate. In a primary battery, the reaction proceeds until all the intercalated hydrogen and doped oxygen fuel is consumed in the production of water. For the secondary cell illustrated in FIGURE 6, continuous sources of hydrogen (660) and oxygen (650) are provided at high pressure The ejection of $H_2O$ can be facilitated by suitably cut crystal surfaces.

The EMF of 1.23V associated with the over-all reaction $2H+O \leftrightarrow H_2O$ maintains the chemical potential of Fe $t_{2g}$ d-band at one side of the wall at about 1.23V above that in oxygen valence band at the other side of the wall. As the topotactic reaction proceeds, this EMF drives an electrical current through an external circuit. Within the wall, with an open circuit, the non-conservative EMF cancels that due to the gradient in the electronic chemical potential.

Such an electrical energy storage device might be charged, reversing the topotactic chemical reactions, and converting water into hydrogen and oxygen. For suitable working materials, such as $La_{1-x}Sr_xFeO_{3-y}$, charging can be also realized upon the exposure the phase wall to visible light.

Another example of a working material would be $SrFeO_x$. As brownmillerite $SrFeO2.5$ with a nominal charge balance $Sr^{2+}$ and $Fe^{3+}$ this is a good electronic insulator and can be hydrated by a topotactic reaction to $HSrFeO3$, an electronic insulator, with a high density of protons and a defect free oxygen lattice, leading to a high proton, but low oxygen ionic conductivity. In contrast the $SrFeO3-\delta$ perovskite phase is an electronic conductor with many oxygen defects leading to a good low temperature oxygen ionic conductor. A topotactic reaction at the phase wall produces $H_2O$.

The foregoing detailed description of the technology herein has been presented for purposes of illustration and description. It is not intended to be exhaustive or to limit the technology to the precise form disclosed. Many modifications and variations are possible in light of the above teaching. The described embodiments were chosen to best explain the principles of the technology and its practical application to thereby enable others skilled in the art to best utilize the technology in various embodiments and with various modifications as are suited to the particular use contemplated. It is intended that the scope of the technology be defined by the claims appended hereto.

**Claims**

1. An electrical energy storage device (200) configured to add electrical energy to the device during charge of the electrical energy storage device and to extract electrical energy from the device during discharge of the electrical energy storage device, comprising:

   a first portion (220) of a working material having a first phase and a first energy density;
a second portion (240) of the working material having a second phase with a second energy density that is different than the first energy density; and
a phase wall (230) separating the first portion (220) and the second portion (240) of the working material,
wherein as the working material undergoes a phase transition between the first phase and second phase, the phase wall moves, and
an external electrical circuit that connects first portion and second portion of the working material, and
the device (200) is configured to be charged from an electrical source and then at a later time discharged into an electrical load.

2. The energy storage device (200) of claim 1, wherein the working material is a prism in which a first terminal (210) of an external electrical circuit is connected to a first prism surface and a second terminal (250) of the external electrical circuit is connected to a second prism surface, wherein the phase wall surface lies between the first prism surface and second prism surface.

3. The electrical energy storage device (200) of claim 1, wherein the first portion (220), the second portion (240), and the phase wall (230) are of the same chemical material.

4. The electrical energy storage device (200) of claim 1, wherein the first phase has a first structure and the second phase has a second structure, wherein the first structure deforms into the second structure within the phase wall.

5. The electrical energy storage device (200) of claim 1, wherein the first phase has a first crystal structure and the second phase has a second crystal structure that differs from the first crystal structure, wherein the first structure deforms into the second structure within the phase wall.

6. The electrical energy storage device (200) of claim 1 wherein the first portion (220) and the second portion (240) are of a different chemical material.

7. The electrical energy storage device (200) of claim 6, wherein the first portion (220) and the second portion (240) differ by one or more chemical species wherein the phase wall delimits the first potion with a higher concentration from the second portion with a lower concentration of those species.

8. The electrical energy storage device of claim 7, wherein a chemical species is added or removed from one or both of the first portion and the second portion, and wherein a chemical reaction occurs within the phase wall, the phase wall being free to move.

9. The electrical energy storage device of claim 1, wherein the terminal voltage reflects the difference in electrical chemical potential between the first portion and the second portion.

10. The electrical energy storage device of claim 1, wherein one of the first portion or the second portion has a first magnetic structure and the remaining portion has a different magnetic structure.

11. The electrical energy storage device of claim 1, wherein one of the first portion or the second portion differs from the remaining portion by an electronic phase transition.

12. The electrical energy storage device of claim 11 in which the electronic phase transition is a Mott transition.

13. The electrical energy storage device of claim 11, wherein the electronic phase transition is an intersite charge transfer.

**Patentansprüche**

1. Ein elektrisches Energiespeichergerät (200), konfiguriert, um elektrische Energie zu dem Gerät während der Ladung des elektrischen Energiespeichergeräts und zur Entnahme elektrischer Energie aus dem Gerät während der Entladung des elektrischen Speichergeräts, bestehend daraus:

ein erster Teil (220) eines Arbeitsmaterials mit einer ersten Phase und einer ersten Energiedichte;
ein zweiter Teil (240) des Arbeitsmaterials hat eine zweite Phase mit einer zweiten Energiedichte, die sich von der ersten Energiedichte unterscheidet; und
eine Phasenwand (230), die den ersten (220) und den zweiten Teil (240) des Arbeitsmaterials trennt,
wobei sich die Phasenwand bewegt, während das Arbeitsmaterial einen Phasenübergang zwischen der ersten und zweiten Phase durchläuft, und
einen externen elektrischen Stromkreis, der den ersten und zweiten Teil des Arbeitsmaterials verbindet, und
das Gerät (200) ist so konfiguriert, dass es von einer elektrischen Quelle geladen und zu einem späteren Zeitpunkt in eine elektrische Last entladen wird.

2. Das Energiespeichergerät (200) von Anspruch 1, bei dem das Arbeitsmaterial ein Prisma ist, bei dem ein erster Anschluss (210) eines externen elektrischen Stromkreises mit einer ersten Prismafläche verbunden ist und ein zweiter Anschluss (250) des externen elektrischen Stromkreises mit einer zweiten Prismaoberfläche, wobei die Phasenwandoberfläche zwischen der ersten und der zweiten Prismafläche liegt.

3. Das elektrische Energiespeichergerät (200) von Anspruch 1, wobei der erste Teil (220), der zweite Teil (240) und die Phasenwand (230) aus demselben chemischen Material bestehen.

4. Das elektrische Energiespeichergerät (200) aus Anspruch 1, wobei die erste Phase eine erste Struktur und die zweite Phase eine zweite Struktur hat, wobei die erste Struktur innerhalb der Phasenwand in die zweite Struktur verformt.

5. Das elektrische Energiespeichergerät (200) von Anspruch 1, bei dem die erste Phase eine erste Kristallstruktur und die zweite Phase eine zweite Kristallstruktur besitzt, die sich von der ersten Kristallstruktur unterscheidet, wobei die erste Struktur innerhalb der Phasenwand in die zweite Struktur verformt.

6. Das elektrische Energiespeichergerät (200) von Anspruch 1, wobei der erste Teil (220) und der zweite Teil (240) aus einem anderen chemischen Material bestehen.

7. Das elektrische Energiespeichergerät (200) von Anspruch 6, wobei der erste Teil (220) und der zweite Teil (240) sich durch eine oder mehrere chemische Spezies unterscheiden, wobei die Phasenwand den ersten Trank mit höherer Konzentration vom zweiten Teil mit niedrigerer Konzentration dieser Arten abgrenzt.

8. Das elektrische Energiespeichergerät von Anspruch 7, bei dem eine chemische Spezies aus einem oder beiden Teilen des ersten und zweiten Teils hinzugefügt oder entfernt wird und eine chemische Reaktion innerhalb der Phasenwand stattfindet, wobei die Phasenwand frei bewegt werden kann.

9. Das elektrische Energiespeichergerät von Anspruch 1, bei dem die Klemmspannung den Unterschied im elektrischen chemischen Potential zwischen dem ersten und dem zweiten Teil widerspiegelt.

10. Das elektrische Energiespeichergerät von Anspruch 1, wobei einer der ersten oder der zweite Teil eine erste magnetische Struktur hat und der verbleibende Teil eine andere magnetische Struktur.

**11.** Das elektrische Energiespeichergerät von Anspruch 1, bei dem sich einer der ersten oder zweiten Teile durch einen elektronischen Phasenübergang vom restlichen Teil unterscheidet.

**12.** Das elektrische Energiespeichergerät von Anspruch 11, bei dem der elektronische Phasenübergang ein Mott-Übergang ist.

**13.** Das elektrische Energiespeichergerät von Anspruch 11, wobei der elektronische Phasenübergang eine Ladungsübertragung zwischen den Standorten ist.

## Revendications

**1.** Un dispositif de stockage d'énergie électrique (200) configuré pour ajouter de l'énergie électrique à la dispositif pendant la charge du dispositif de stockage d'énergie électrique et pour extraire de l'énergie électrique de celui-ci lors de la décharge du dispositif de stockage d'énergie électrique, comprenant :

une première portion (220) d'un matériau de travail ayant une première phase et une première densité d'énergie ;
une seconde portion (240) du matériau de travail ayant une seconde phase avec une seconde densité d'énergie différente de la première densité d'énergie ; et
un paroi de phase (230) séparant la première portion (220) et la seconde (240) du matériau de travail,
où, à mesure que le matériau de travail subit une transition de phase entre la première et la deuxième phase, la paroi de phase se déplace, et
un circuit électrique externe qui relie la première et la seconde partie du matériau de travail, et
le dispositif (200) est configuré pour être chargé à partir d'une source électrique puis déchargé ultérieurement dans une charge électrique.

**2.** Le dispositif de stockage d'énergie (200) de la revendication 1, où le matériau de travail est un prisme dans lequel une première borne (210) d'un circuit électrique externe est connectée à une première surface prismaticale et une seconde borne (250) du circuit électrique externe est connectée à une seconde surface prismatice, où la surface de la paroi de phase se situe entre la première surface du prisme et la surface du second prisme.

**3.** Le dispositif de stockage d'énergie électrique (200) de la revendication 1, où la première partie (220), la seconde partie (240) et la paroi de phase (230) sont du même matériau chimique.

**4.** Le dispositif de stockage d'énergie électrique (200) de la revendication 1, où la première phase possède une première structure et la seconde phase une seconde structure, où la première structure se déforme en la seconde structure à l'intérieur de la paroi de phase.

**5.** Le dispositif de stockage d'énergie électrique (200) de la revendication 1, où la première phase possède une première structure cristalline et la seconde phase une seconde structure cristalline différente de la première structure cristalline, où la première structure se déforme en seconde structure à l'intérieur de la paroi de phase.

**6.** Le dispositif de stockage d'énergie électrique (200) de la revendication 1 où la première partie (220) et la seconde partie (240) sont faites d'un matériau chimique différent.

**7.** Le dispositif de stockage d'énergie électrique (200) de la revendication 6, où la première partie (220) et la seconde partie (240) diffèrent par une ou plusieurs espèces chimiques où la paroi de phase délimite la première potion à concentration plus élevée de la seconde portion à plus faible concentration de ces espèces.

**8.** Le dispositif de stockage d'énergie électrique de la revendication 7, dans lequel une espèce chimique est ajoutée ou retirée d'une ou des deux parties de la première et de la seconde partie, et où une réaction chimique se produit à l'intérieur de la paroi de phase, la paroi de phase étant libre de se déplacer.

**9.** Le dispositif de stockage d'énergie électrique de la revendication 1, où la tension terminale reflète la différence de potentiel chimique électrique entre la première et la seconde partie.

**10.** Le dispositif de stockage d'énergie électrique de la revendication 1, où l'une des premières parties ou la seconde partie possède une première structure magnétique et la portion restante une structure magnétique différente.

**11.** Le dispositif de stockage d'énergie électrique de la revendication 1, où l'une des premières parties ou la seconde partie diffère de la partie restante par une transition de phase électronique.

**12.** Le dispositif de stockage d'énergie électrique de la revendication 11, dans lequel la transition de phase électronique est une transition de Mott.

**13.** Le dispositif de stockage d'énergie électrique de la revendication 11, où la transition de phase électronique est un transfert de charge inter-sites.

Domain Wall

+ve terminal

low energy
magnetisation direction

high energy
magnetisation direction

direction of wall movement

-ve terminal

110    120         130      140    150

Magnetic Field

FIGURE 1

FIGURE 2

FIGURE 3

EP 3 766 114 B1

FIGURE 4

FIGURE 5

FIGURE 6

EP 3 766 114 B1

## REFERENCES CITED IN THE DESCRIPTION

### Patent documents cited in the description

- US 62644068
- US 20190288278 A
- WO 2007015475 A1, Barnes

### Non-patent literature cited in the description

- **INTERNATIONAL UNION OF PURE AND APPLIED CHEMISTS (IUPAC**. Definitions of terms relating to phase transitions of the solid state. *IUPAC*, 2004, vol. 76, 1985
- **IUPAC**. *A change in the nature of a phase as a result of some variation in externally imposed conditions, such as temperature, pressure, activity of a component or a magnetic, electric or stress field*
- **ZHU, XIAOJIAN et al.** In Situ Nanoscale Electric Field Control of Magnetism by Nanoionics. *Advanced Materials*, 01 September 2016, vol. 28 (35), ISSN 0935-9648, 7658-7665
- **TSUNEO MATSUI** ; **J. BRUCE WAGNER JR.** *J. Electrochem. Soc.*, 1977, vol. 124, 1141
- Control of the domain wall motion in cylindrical magnetic wires. **CHIZHIK, ALEXANDER et al.** APPLIED PHYSICS LETTERS. AMERICAN INSTITUTE OF PHYSICS, 01 August 2016, vol. 109
- High recoverable energy storage density and large piezoelectric response in (Bi0.5Na0.5)TiO3-PbTiO3 thin films prepared by a sol-gel method. **LI PENG et al.** JOURNAL OF THE EUROPEAN CERAMIC SOCIETY. ELSEVIER, 14 April 2017, vol. 37, 3319-3327
- Large enhancement of the recoverable energy storage density and piezoelectric response in relaxor-ferroelectric capacitors by utilizing the seeding layers engineering. **XIE ZHENKUN et al.** APPLIED PHYSICS LETTERS. AMERICAN INSTITUTE OF PHYSICS, 18 May 2015, vol. 106
- **KITTEL, CHARLES**. Introduction to solid state physics. Wiley, 2005, 680
- Strain effects in low-dimensional transition metal oxides. **CAO, J. et al.** MATERIALS SCIENCE AND ENGINEERING: R: REPORTS. ELSEVIER, 08 January 2011, 35-52
- **K. BOUKHEDDADEN et al.** *Physica B*, 2015, http://dx.doi.org/10.1016/i.physb.2015.09.054i
- **HAI et al.** Electromotive force and huge magnetoresistance in magnetic tunnel junctions. *Science*, 2009, vol. 458, 489
- **BARNES** ; **MAEKAWA**. Generalization of Faraday's law to include nonconservative spin forces. *Phys. Rev. Lett.*, 2007, vol. 98, 246601
- **HAYASHI et al.** Time-domain observation of the spin-motive force in permalloy nanowires. *Phys. Rev. Lett.*, 2012, vol. 108, 147202
- **B. FISCHER**. *J.Phys C: Sold St. Phys*, 1975, vol. 8, 2072-6
- **Q. GU** ; **A FALK** ; **J. WU** ; **L. OUYANG** ; **H. PARK**. Current-Driven Phase Oscillation and Domain-Wall Propagation in WxV1-xO2 Nanobeams. *Nano Lett*, 2007, vol. 10, 2003-2011
- **CAO et al.** Such devices exhibit a dynamical negative resistance and due to a parallel capacitance function as oscillators up to 5MHz. *Following Fischer*, 1975
- **J. ZHANG et al.** Nano-Resolved Current-Induced Insulator-Metal Transition in the Mott Insulator Ca2RuO. *Phys. Rev. X*, 15 February 2019, vol. 9, 011032
- **NAKAMURA, F. et al.** Electric-field-induced metal maintained by current of the Mott insulator Ca2RuO. *Sci. Rep.*, 2013, vol. 3, 2536
- **J. A. CORNEJO JIMENEZ**. Study of the fabrication of VO2 devices for application on Oscillatory Neural Networks. *master's thesis*, 14 August 2020, https://webthesis.biblio.polito.it/16023/1/tesi.pdf
- **NAGAOSA** ; **TOKURA**. Emergent electromagnetism in solids. *Phys. Scr.*, 2012, 014020
- **M.V. BERRY**. Quantal Phase Factors Accompanying Adiabatic Changes. *Proc. Royal Soc.A*, 1984, vol. 392, 45-57, https://doi.org/10.1098/rspa.1984.0023
- **BORN** ; **OPPENHEIMER**. Zur Quanten theorie der Molekein. *Annalen der Physik*, 1927, vol. 389, 457-484
- **ALIPPI et al.** Strained tetragonal states and Bain paths in metals. *Phys. Rev. Lett.*, 1997, vol. 78, 3892